# EUROPEAN PATENT APPLICATION

(11) **EP 0 541 243 A1**
(43) Date of publication of application: **12.05.1993**
(21) Application number: 92309117.7
(22) Date of filing: 07.10.1992
(51) Int. Cl.: H03G 5/28

(54) **HF amplifier bandwidth control**

(30) Priority: 08.11.1991 GB 9123792
(71) Applicant: NORTHERN TELECOM LIMITED, Montreal, Quebec H2Y 3Y4 (CA)
(72) Inventor: Goodchild, Garth, Billericay, Essex CM11 2XU (GB)
(74) Representative: Ryan, John Peter William

(57) **Abstract**

A method of controlling the bandwidth in a high frequency transimpedance feedback amplifier comprising the step of applying a d.c. control current to control the forward gain of a voltage amplifying transistor stage in the amplifier the gain of which amplifying stage is dependent on the collector current of a transistor in the stage.

## Description

This invention relates to a method and means for controlling the bandwidth of a high frequency amplifier such as may be used in optical receivers in high bit rate optical telecommunications systems.

In the manufacture of optical receiver front ends for bit rates up to IGbit/s a discrete realisation is often used. The technology employed is usually surface mount components on a glass fibre printed circuit board. The front end amplifier is normally a transimpedance feedback design.

Due to the variation of component tolerances and printed circuit board geometry from model to model variation of bandwidth often occurs. This variation of bandwidth, if not controlled, will cause a degradation of the sensitivity of the whole receiver.

The usual way of controlling the bandwidth of a transimpedance feedback amplifier is to have a "select-on-test" element in the receiver chain to adjust the bandwidth. This is commonly in the amplifier stage following the front end low noise input stage and is done by selecting one of a range of attenuation components in the signal path.

From British patent No. 564 444 it is known to change the gain of an amplifier by a change in direct current applied directly in the feedback circuit. A similar arrangement is disclosed in British patent No. 479 599.

According to the present invention there is provided a method of controlling the bandwidth of a transimpedance feedback amplifier having a variable gain voltage amplifying stage characterised in that a d.c. control signal is applied to vary the forward gain of the voltage amplifying stage thereby to control the amount of gain in the feedback loop and hence the bandwidth of the amplifier.

Embodiments of the invention will now be described with reference to the accompanying drawings, in which:-
Fig. 1 is a schematic block diagram of a high frequency transimpedance feedback amplifier, and
Fig. 2 is a circuit diagram of the amplifier of Fig. 1.

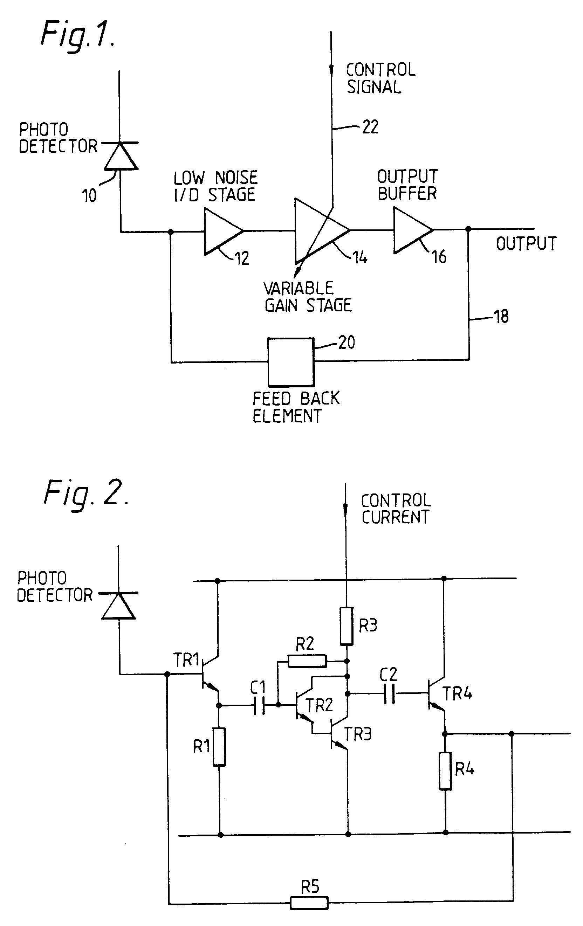

In the arrangement shown in Fig. 1, which represents the front end of a receiver in a high frequency, e.g. 1 Gbit/s optical transmission system, the output of a photodetector 10 provides an input signal for the receiver front end. The input signal is applied to a first low noise input stage 12 the output of which is fed to a second variable gain stage 14. The output of the variable gain stage is fed to a third output buffer stage 16 which provides the front end output and drives a feedback loop 18. The feedback loop includes a feedback element 20 and the feedback is applied to the input to the first stage 12. A d.c. control signal 22 is applied to the variable gain stage 14 to control the gain thereof. Variation of the forward gain of stage 14 in turn controls the amount of feedback. The bandwidth of a feedback amplifier is a function of the amount of feedback applied in the loop so that bandwidth adjustment can be made simply by varying the amount of forward gain.

In the circuit shown in Fig. 2 transistor TR1 is a low noise current amplifier. Transistors TR2 and TR3 form a voltage amplifying Darlington pair stage the gain of which is dependent on collector current. Transistor TR4 is a buffer stage to drive the feedback path via resistor R5 and also to provide the amplifier output. Capacitors C1 and C2 provide d.c. decoupling of the variable gain stage. Resistors R1 and R4 form part of the fixed bias arrangements for TR1 and TR4. A d.c. control current is applied to the collectors of TR3 and TR4 via resistor R3 and also to the base of TR2 via resistor R2 in series with R3. As the current to TR3 and TR4 is varied the gain of the stage varies. This changes the amount of forward gain of the amplifier and hence the amount of feedback applied via R5. As a result the bandwidth changes. On the design this was invented for the variation is from approximately 200 to 400 MHz by a variation in control current of 15 to 30 mA. The control current in this case was generated by a simple transistor current source (not shown) varied by a "cold" select-on-test resistor.

This technique has application in other fields, wherever bandwidth control is required in a feedback amplifier. It is especially useful for high frequency as the control signal is simple d.c.

## Claims

1. A method of controlling the bandwidth of a transimpedance feedback amplifier having a variable gain voltage amplifying stage (14) characterised in that a d.c. control signal (22) is applied to vary the forward gain of the voltage amplifying stage thereby to control the amount of gain in the feedback loop (18,20) and hence the bandwidth of the amplifier.

2. A method according to claim 1 characterised in that the voltage amplifying stage (14) is a transistor stage the gain of which is dependent on the collector current of the transistor(s) (TR2, TR3) and the d.c. control signal is applied to vary the collector current.

3. A transimpedance feedback amplifier having a variable gain voltage amplifying stage (14) and characterised in that the amplifier includes means for applying a d.c. control signal (22) to vary the forward gain of the amplifying stage thereby to control the amount of gain in the feedback loop (18,20) and hence the bandwidth of the amplifier.

4. An amplifier according to claim 3 characterised in that the voltage amplifying stage (14) comprises first and second transistors (TR2, TR3) connected in a Darlington pair configuration and the d.c. control current (22) is applied to the collectors of the pair.
